(19) Europäisches Patentamt
European Patent Office
Office européen des brevets

(11) **EP 2 020 079 B1**

(12) **EUROPÄISCHE PATENTSCHRIFT**

(45) Veröffentlichungstag und Bekanntmachung des Hinweises auf die Patenterteilung:
**27.06.2012   Patentblatt 2012/26**

(21) Anmeldenummer: **07725405.0**

(22) Anmeldetag: **21.05.2007**

(51) Int Cl.:
**H03D 13/00** *(2006.01)*

(86) Internationale Anmeldenummer:
**PCT/EP2007/004498**

(87) Internationale Veröffentlichungsnummer:
**WO 2007/134826 (29.11.2007 Gazette 2007/48)**

(54) **SELBSTABGLEICHENDE DRIFTFREIE HOCHFREQUENZ -PHASENDETEKTOR-SCHALTUNG**

SELF-COMPENSATING DRIFT-FREE RADIO-FREQUENCY PHASE DETECTOR CIRCUIT

CIRCUIT DE DÉTECTEUR DE PHASE HAUTE FRÉQUENCE SANS DÉRIVE AUTO-AJUSTABLE

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **23.05.2006   DE 102006024210**

(43) Veröffentlichungstag der Anmeldung:
**04.02.2009   Patentblatt 2009/06**

(73) Patentinhaber: **Deutsches Elektronen-Synchrotron DESY**
**22607 Hamburg (DE)**

(72) Erfinder: **LUDWIG, Frank**
**22846 Norderstedt (DE)**

(74) Vertreter: **UEXKÜLL & STOLBERG**
**Patentanwälte**
**Beselerstrasse 4**
**22607 Hamburg (DE)**

(56) Entgegenhaltungen:
**US-A- 3 761 829      US-A- 4 975 650**
**US-A- 5 614 861      US-A- 5 659 263**
**US-A- 5 870 670      US-A1- 2002 181 619**
**US-A1- 2005 237 120**

EP 2 020 079 B1

## Beschreibung

Die vorliegende Erfindung betrifft allgemein ein Detektor-System, beispielsweise zur Synchronisation von einem FEL ("Freie-Elektronen-Laser"), sowie insbesondere eine kombinierte, rauscharme, selbstabgleichende und nahezu driftfreie Hochfrequenz-Phasendetektor-Schaltung für kontinuierliche Messungen und speziell ein selbst-kalibrierendes, nahezu driftfreies Phasendetektor-Modul, das vorzugsweise, aber nicht ausschließlich, in einer solchen Phasendetektor-Schaltung Anwendung findet.

Der Erfindung liegt die Erkenntnis zugrunde, dass herkömmliche Detektor-Systeme im Wesentlichen aufgrund ihrer Temperaturabhängigkeit eine Drift im Bereich von mehreren Pikosekunden aufweisen. Dieser Wert ist für viele Anwendungen zu hoch und liegt beispielsweise wesentlich über den zur Synchronisation des sogenannten XFEL ("Röntgenlicht-Freie-Elektronen-Laser" - ein europäisches Röntgenlaserprojekt, bei dem Elektronen zunächst auf hohe Energien beschleunigt und danach zur Aussendung von hochintensiven Röntgenlaserblitzen gebracht werden) als notwenig erachteten 10-100 Femtosekunden. Da die erhältlichen driftarmen Detektor-Systeme oft erhebliches Rauschen zeigen, sind sie in vielen Fällen für die praktische Anwendung ungeeignet.

Beispiele von bekannten Detektor-Systemen sowie von Schaltungen zur Verminderung von Drift und Rauschen sind beispielsweise in den Dokumenten US 3,883,755; US 4,042,885; US 4,155,050; US 4,389,621; US 4,728,884; US 4,937,537; US 5,210,509; US 6,087,897; US 6,167,242; US 6,242,974; US 6,340,903; US 6,476,671; US 6,781,450; US 6,937,684; EP 0 540 052; EP 1 184 972; WO 99/36792; und WO 01/20350 gezeigt, die jedoch alle keine Lösungen für die vorstehend genannte Problematik offenbaren.

Im Dokument US5614861 ist eine Hochfrequenz-Phasendetektor-Schaltung offenbart. Es ist Aufgabe der vorliegenden Erfindung, eine Hochfrequenz-Phasendetektor-Schaltung zur Verfügung zu stellen, die äußerst rauscharm und im Wesentlichen driftfrei ist, und die außerdem die Eigenschaften eines Selbstabgleichs hat. Eine weitere Aufgabe der vorliegenden Erfindung besteht darin, ein selbst-kalibrierendes, nahe driftfreies Phasendetektor-Modul zur Verfügung zu stellen, das vorzugsweise in einer Hochfrequenz-Phasendetektor-Schaltung Anwendung findet.

Zur Lösung dieser Aufgaben dienen ein selbst-kalibrierendes Phasendetektor-Modul mit den Merkmalen des unabhängigen Patentanspruchs 1. Vorteilhafte Ausführungsformen der Erfindung sind in den jeweiligen Unteransprüchen angegeben.

Die Erfindung wird im Folgenden anhand eines Ausführungsbeispiels in den Zeichnungen erläutert, in denen:

Figur 1     das Grundprinzip zur phasenstarren Erzeugung von Frequenzen mittels einer PLL (Phase-Lock-Loop) zeigt;

Figur 2     ein schematisches Blockdiagramm von einer kombinierten, rauscharmen, selbstabgleichenden, nahezu driftfreien Phasendetektor-Schaltung für kontinuierliche Messungen zeigt;

Figur 3     eine Darstellung von einem ersten Ausführungsbeispiel des selbstabgleichenden, nahezu driftfreien Hochfrequenz-Phasendetektor-Moduls aus Figur 2 zeigt;

Figur 4     eine Darstellung von einem zweiten Ausführungsbeispiel des selbstabgleichenden, nahezu driftfreien Hochfrequenz-Phasendetektor-Moduls aus Figur 2 zeigt; und

Figur 5     eine Darstellung von einem dritten Ausführungsbeispiel des selbstabgleichenden, nahezu driftfreien Hochfrequenz-Phasendetektor-Moduls aus Figur 2 zeigt.

Zur Messung und Synchronisation von Hochfrequenzsignalen werden in PLLs (Phase-Lock-Loop) üblicherweise Phasendetektor-Schaltungen eingesetzt. Insbesondere bei der Synchronisation, Erzeugung, Verteilung und Verifikation von verschiedenen, zueinander feststehenden Frequenzen bezüglich ihres minimalsten Phasenrausch- und Driftunterschieds, werden Phasendetektor-Schaltungen in PLLs eingesetzt.

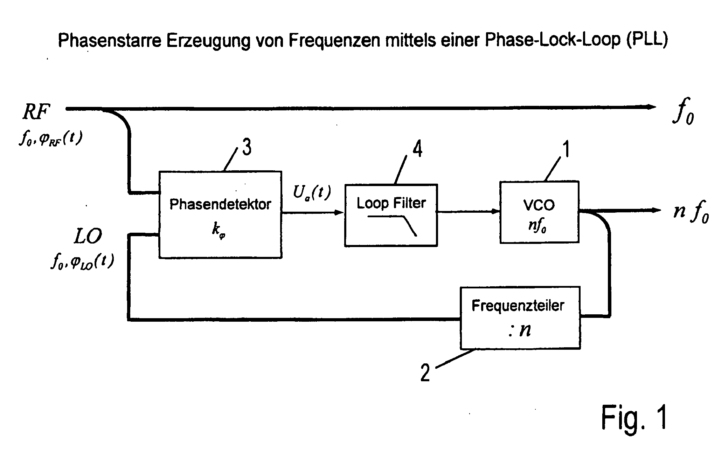

Figur 1 zeigt das Grundprinzip zur phasenstarren Erzeugung von Frequenzen mittels einer PLL. Hierbei erzeugt ein VCO 1 (Voltage Controlled Oscillator) eine mit n vervielfachte Frequenz $n\,f_0$, die wiederum, geteilt durch n mittels eines Frequenzteilers 2, durch einen Phasendetektor 3 mit der ursprünglichen Frequenz RF verglichen wird. Über ein Filter 4 (Loop-Filter) wird dann die Frequenz des VCO 1 und damit die gewünschte Phase eingeregelt.

Bei der zeitjitterfreien Verteilung und Synchronisation von Signalen im fs-Bereich sind jedoch minimalste Phasenrausch- und Driftunterschiede wesentlich. Insbesondere für die Überwachung und Rückregelung von Phasenschwankungen werden daher wesentlich bessere drift- und rauschärmere Phasendetektoren benötigt als im Stand der Technik bekannt sind. Die derzeit erhältlichen Phasendetektor-Systeme genügen nicht den hohen Anforderungen bezüglich Drift- und Rauscheigenschaften, wie beispielsweise zum Betrieb eines XFEL (X-Ray-Free-Electron-Laser)-Beschleunigers erforderlich ist.

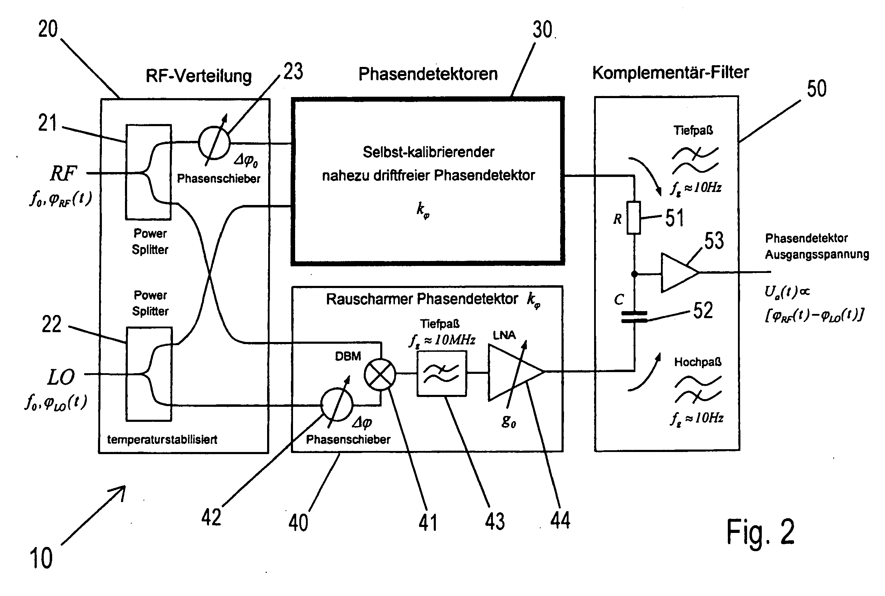

Zur Erfüllung der Drift- und Rauschanforderungen wird daher gemäß der vorliegenden Erfindung und unter Bezugnahme auf Figur 2 eine kombinierte, selbstabgleichende, nahezu driftfreie und rauscharme Phasendetektor-Schaltung 10 zur Verfügung gestellt, die eine RF-Verteilungseinrichtung 20, ein selbst-kalibrierendes (d.h. selbstabgleichendes), nahezu driftfreies Phasendetektor-Modul 30, ein rauscharmes Phasendetektor-Modul 40 und eine komplementäre Filtereinrichtung 50 beinhaltet. Hierbei wird im Grundsatz die zu messende Eingangsphasendifferenz zweier sinusförmiger Hochfrequenzsignale RF, L0 gleicher Frequenz $f_0$ in einem Frequenzbereich von etwa 1 GHz über Leistungsteiler 21, 22 (Power Splitter) jeweils nahezu driftfrei bzw. rauscharm gemessen und im Basisband mit Hilfe der komplementären Filtereinrichtung 50 kombiniert, um die Eingangsphasendifferenz zurückzugewinnen. Etwaige Phasenunterschiede $\Delta\varphi_0$, verursacht zum Beispiel durch Laufzeitunterschiede, können durch einen Phasenschieber 23 oder durch Kabellängenanpassung kompensiert werden. Um auftretende Phasendriften der Leistungsteiler 21, 22 und der Kabel selbst zu minimieren, wird die RF-Verteilungseinrichtung 20 auf bekannte Weise temperaturstabilisiert. Damit die Rückgewinnung des zeitabhängigen Phasendifferenzsignals möglichst formgetreu und unabhängig von temperaturabhängigen Bauteiltoleranzen des komplementären Filters 50 ist, beinhaltet der Filter einen *RC*-Tiefpass/Hochpass erster Ordnung, der einen Widerstand 51 sowie eine Kapazität 52 aufweist, mit automatisch gegebenen gleichen Eckfrequenzen gefolgt von einem Impedanzwandler 53. Die Eckfrequenz des komplementären Filters 50 beträgt typischerweise etwa 1-100 Hz. Durch die Frequenzaufteilung der komplementären Filtereinrichtung 50 sind die Drifteigenschaften des rauscharmen Phasendetektor-Moduls 40 bzw. die Rauscheigenschaften des nahezu driftfreien Phasendetektor-Moduls 30 vernachlässigbar.

Wie in Figur 2 zu sehen ist, weist die Phasendetektor-Schaltung 10 eine RF-Verteilungseinrichtung 10 mit zwei Leistungsteilern (Power Splitter) 21, 22 und einem Phasenschieber 23, zwei Phasendetektor-Module 30 und 40, sowie eine komplementäre Filtereinrichtung 50 auf. Jeder der Leistungsteiler 21 und 22 hat einen Eingang und zwei Ausgänge. Am Eingang des ersten Leistungsteilers 21 liegt das Frequenzsignal RF($f_0$) an, und am Eingang des zweiten Leistungsteilers 22 liegt das Frequenzsignal LO($f_0$) an. Beide Frequenzsignale RF($f_0$) und LO($f_0$) werden durch die zugehörigen Leistungsteiler 21 bzw. 22 gespalten und jeweils einem Eingang der beiden Phasendetektor-Module 30, 40 zugeführt. Die Ausgänge der beiden Phasendetektor-Module 30, 40 werden jeweils der komplementären Filtereinrichtung 50 zugeführt, wobei der Ausgang des selbstabgleichenden, nahezu driftfreien Phasendetektor-Moduls 30 dem Widerstand 51 und der Ausgang des rauscharmen Phasendetektor-Moduls 40 der Kapazität 52 zugeführt wird. Der Widerstand 51 und die Kapazität 52 bilden den Hochpass/Tiefpass-Filter, dem ein Verstärker 53 nachgeschaltet ist.

Zur rauscharmen Phasendetektion wird, wie in Figur 2 gezeigt, ein passiver Diodenmischer 41 (DBM = double balanced diode mixer), der mit einem manuellen Phasenschieber 42 ($\Delta\varphi$) gekoppelt und mit einem Tiefpassfilter 43 (Eckfrequenz von typischerweise etwa 10 MHz) verbunden ist, zur Abtrennung der Summenfrequenz eingesetzt. Die Phasendifferenz wird am Ausgang des Tiefpassfilters 42 in Form einer Spannung über einen rauscharmen, dc-gekoppelten Operationsverstärker 44 (LNA) mittels des integrierten Schaltkreis AD797 (Analog Devices) ausgegeben. Damit die Rückgewinnung des Phasendifferenzsignals formgetreu ist, wird die Verstärkung $g_0$ des Operationsverstärkers 44 so eingestellt, dass die Phasen-zu-Spannung-Konversionskoeffizienten $k_\varphi$ beider Phasendetektor-Module (d.h. driftfreies Phasendetektor-Modul 30 und rauscharmes Phasendetektor-Modul 40) möglichst gleich sind. Dies ist für den Betrieb der Phasendetektor-Schaltung 10 innerhalb einer PLL nicht unbedingt notwendig, da die Phasendetektor-Schaltung 10 dort am Ausgang $U_\alpha(t)$ um Null betrieben wird.

Der Einsatz eines Mischers im Kleinsignalbetrieb als Phasendetektor-Schaltung erfordert im Mittel die Einhaltung einer 90 Grad Phasendifferenz zwischen den zu vergleichenden Frequenzen, was durch den Einsatz des Detektors in einer PLL incl. Rückregelschleife, typischerweise bestehend aus einem Integrator und VCO erfüllt wird. In dieser Konfiguration fungiert der kombinierte Phasendetektor als Nulldetektor, so dass etwaige Driften der Phasen zu Spannung Konversionskoeffizienten selbst vernachlässigbaren Einfluss haben und lediglich die Offsetdriften des Phasendetektors kompensiert werden müssen, welches Gegenstand der folgenden Ausführungen ist.

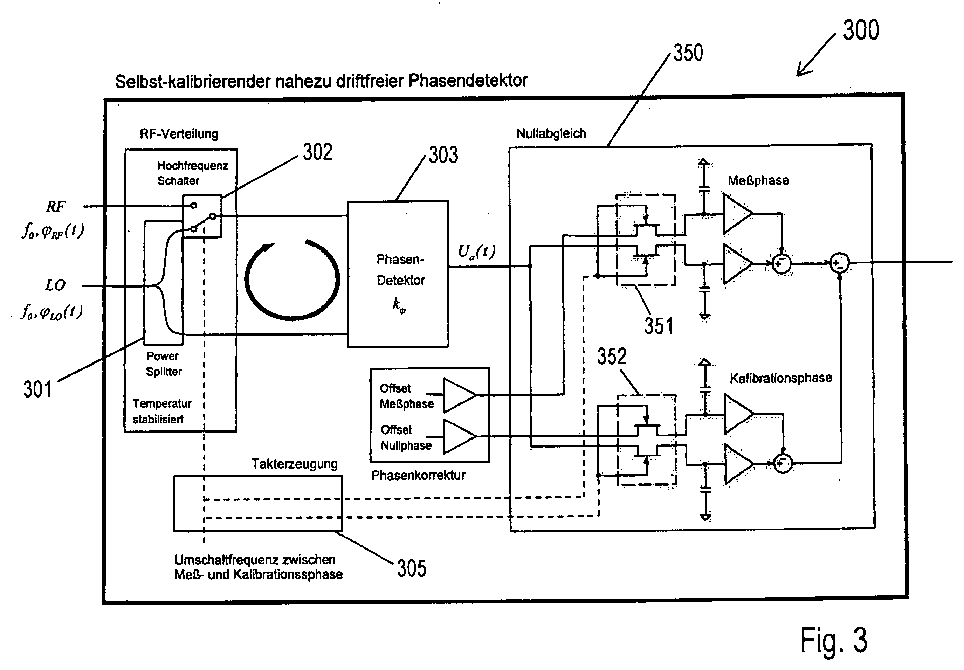

Es wird nun auf Figur 3 Bezug genommen, in der ein erstes Ausführungsbeispiel des selbst-kalibrierenden (d.h. selbstabgleichenden), nahezu driftfreien Phasendetektor-Moduls 30 aus Figur 2 gezeigt ist, das in Figur 3 mit dem Bezugszeichen 300 bezeichnet ist. Der eigentliche Selbstabgleich des nahezu driftfreien Phasendetektor-Moduls 300 wird gemäß dem in Figur 3 gezeigten ersten Ausführungsbeispiel der vorliegenden Erfindung mit Hilfe eines Leistungsteilers 301 (Power Splitter) und durch die Einführung eines Nullabgleichs 350 am Ausgang eines Phasendetektors 303 während der Kalibrationsphase durchgeführt. Hierbei werden die phasendriften und tieffrequenten 1/f-Phasenrauschkomponenten des die Signale RF, L0 liefernden Referenzgenerators, des Phasendetektors 303, der Zuleitungen und des Verstärkers (nicht gezeigt) innerhalb der Kalibrationsschleife unterdrückt, da dem Phasendetektor 303 zwei aus einer Referenzquelle stammende, in sich voll korrelierte Signale RF, L0 zur Verfügung stehen, deren Phasendifferenz Null sein muss. Auftretende Schwankungen am Ausgang des Phasendetektors 303 können so während der Kalibrationsphase mit Hilfe einer Sample & Hold-Stufe gespeichert werden. Unter der Annahme, dass während der Messphase die zuvor in der Kalibrationsphase gespeicherten Phasendriften des Phasendetektors 303 nahezu konstant geblieben sind, sich die zu gemessene Phasendifferenz additiv verhält und der Hochfrequenzschalter 302 selbst nur konstante Phasenbeiträge liefert, kann die zu messende Phasendifferenz durch Subtraktion der zuvor gespeicherten Phasendriften des Detektors ermittelt werden.

**EP 2 020 079 B1**

Wie in Figur 3 gezeigt, werden dem selbst-kalibrierenden, nahezu driftfreien Phasendetektor-Modul 300 zwei Frequenzsignale RF, LO zugeführt. Dabei wird das Frequenzsignal LO dem Leistungsteiler 301 zugeführt, und das Frequenzsignal RF wird dem ersten Eingang des Hochfrequenzschalters 302 zugeführt. Wie weiter in Figur 3 zu sehen, wird ein erstes Ausgangssignal des Leistungsteilers 301 dem zweiten Eingang des Hochfrequenzschalters 302 zugeführt. Der Ausgang des Hochfrequenzschalters 302 wird dann einem ersten Eingang des Phasendetektors 303 zugeführt, und ein zweites Ausgangssignal des Leistungsteilers wird dem zweiten Eingang des Phasendetektors 303 zugeführt. Der Ausgang des Phasendetektors 303 wird mit Hilfe einer Verstärkerstufe verstärkt und einem Nullabgleich 350 unterzogen. Der Hochfrequenzschalter 302 hat einen zusätzlichen Steuereingang, an den eine Umschaltfrequenz von einer Takterzeugungseinrichtung 305 angelegt ist, um die Stellung des Hochfrequenzschalters 302 zwischen einer Messphase und einer Kalibrationsphase umschalten zu können. Während der Kalibrationsphase (Stellung des Hochfrequenzschalters wie in Figur 3 gezeigt) ist der erste Ausgang des Leistungsteilers 301 mit dem ersten Eingang des Phasendetektors 303 verbunden, und der zweite Ausgang des Leistungsteilers 301 ist mit dem zweiten Eingang des Phasendetektors 303 verbunden. Die an dem Leistungsteiler 301 erzeugten, voll korrelierten Hochfrequenzsignale dienen somit während der Kalibrationsphase als Nullabgleichssignale für den Detektorausgang. Während der Messphase, in der der erste Eingang des Hochfrequenzschalters 302, an dem das Frequenzsignal RF anliegt, mit dem Ausgang des Hochfrequenzschalters 302 gekoppelt ist, erscheint zusätzlich am Ausgang des Phasendetektors 303 die zu messende Phasendifferenz, so dass mit Hilfe einer Sample & Hold-Stufe die zuvor während der Kalibrierungshase gespeicherte Driftfehlspannung beim Nullabgleich berücksichtigt werden kann. Zur effektiven Unterdrückung von Driften und niederfrequentem 1/f-Rauschen sollte die Umschaltfrequenz so hoch wie möglich gewählt werden.

Im Folgenden wird aufgezeigt, dass der Kalibrationsprozess unter Benutzung von zwei voll korrelierten Signalen, die von einer Referenzquelle stammen, unabhängig vom Phasenrauschen bzw. Driften der Referenzquelle selbst ist und damit sehr wirkungsvoll ist. Der Phasendetektor 303 misst während der Messphase die Eingangsphasendifferenz $\varphi_{RF} - \varphi_{LO}$ der Signale RF und L0 über den Konversionskoeffizienten $k_\varphi$ in Form einer Spannung

$$U_a(t) = k_\varphi [\varphi_{RF}(t) - \varphi_{LO}(t)] \, , \qquad (1)$$

bzw. wird im Frequenzraum beschrieben durch die Spektraldichte des Spannungsrauschens $S_U(f)$, Phasenrauschens an den Eingängen $S_{\varphi.RF}(f)$, $S_{\varphi LO}(f)$ und dessen Korrelation $\gamma_{RF.LO}(f)$ mit

$$S_U(f) = 2k_\varphi^2 S_\varphi(f) \, , \quad S_\varphi(f) = S_{\varphi,RF}(f) + S_{\varphi,LO}(f) - 2\gamma_{RF.LO}(f)\sqrt{S_{\varphi,RF}(f)}\sqrt{S_{\varphi,LO}(f)} \, . \quad (2)$$

Während der Kalibrationsphase sind die von der Referenzquelle stammenden Signale voll korreliert und Gleichung (2) ergibt sich mit $\gamma_{RF.LO}(f) = 1$ zu

$$S_\varphi(f) = \left(\sqrt{S_{\varphi,RF}(f)} - \sqrt{S_{\varphi,LO}(f)}\right)^2 . \qquad (3)$$

Da die Signale über den Leistungsteiler 301 von einer Referenzquelle stammen, gilt $S_{\varphi,RF}(f) = S_{\varphi,LO}(f)$ und mit Gleichung (3) $S_\varphi(f) = 0$ bzw. $S_U(f) = 0$ oder $U_\alpha(t) = 0$. Anderweitig auftretende Phasenrauschkomponenten oder Driften innerhalb der Kalibrationsschleife können somit unterdrückt werden. Zur Minimierung etwaiger auftretender Phasendriften des Leistungsteilers 301 selbst wird die RF-Verteilung selbst temperaturstabilisiert. Laufzeitunterschiede von Kabellängen werden mittels Phasenkorrektur als Offsets während der Mess- bzw. Kalibrationsphase in den Abgleich eingespeist.

Für den Phasendetektor 303 wird ein konventioneller integrierter Schaltkreis HMC439 (Hittite Microwave Coorperation) mit einem eindeutigen Phasenmessbereich von +/- 180 Grad benutzt. Um die Phasendriften des Detektors wirkungsvoll zu unterdrücken sollte die Umschaltfrequenz zwischen Mess- und Kalibrationsphase mit ca. 10 kHz möglichst hoch gewählt werden. Die Umschaltung der Hochfrequenz erfolgt mit einem konventionell erhältlichen integrierten Schaltkreis HMC349 mit Anstiegszeiten im ns-Bereich und hoher Isolation. Die Subtraktion selbst kann mittels einer analog zu digital Wandlung durchgeführt werden oder mit Hilfe zweier Sample & Hold-Stufen mit anschließender analoger

4

Differenzbildung. Damit dieser Vorgang möglichst driftfrei arbeitet, werden thermisch gekoppelte zweifach JFET's 351, 352 mit symmetrischer Ansteuerung, Speisung und Haltekondensatoren als Schalter verwendet, von dem jeweils ein JFET Zweig nach Abbildung ohne Signal mit einer konstanten Spannung gespeist wird. Nach anschließender Differenzbildung können so Umladeeffekte der Haltekondensatoren aufgrund der intrinsischen Drain-, Gate- und Source- JFET-Kapazitäten bis in den µV Bereich reduziert werden. Damit die Fehler der Signalabtastung beim Nullabgleich am Ausgang vernachlässigt werden können, wird die Umschaltfrequenz, die durch die Takterzeugungseinrichtung 305 erzeugt wird, die mit den JFET's 351 und 352 gekoppelt ist, mit ca. 10 kHz wesentlich höher gewählt als die Eckfrequenz des komplementären Filters, die etwa 1-100 Hz beträgt. Zusätzlich können diese Fehler für gegen Null gehende Phasendifferenzen im PLL-Betrieb vernachlässigt werden.

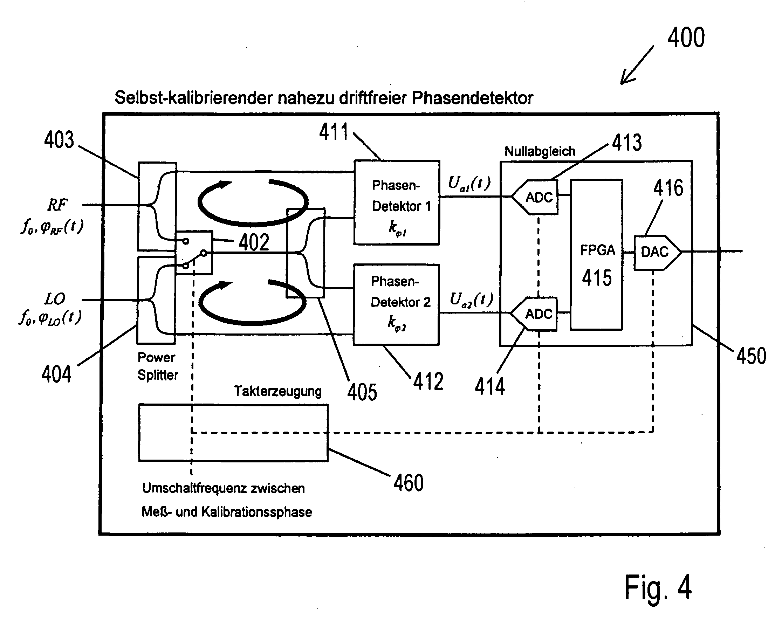

Figur 4 zeigt einen selbst-kalibrierenden, nahezu driftfreien Phasendetektor 400 der Schaltung aus Figur 2, der eine Abwandlung des Phasendetektors 300 aus Figur 3 ist. Bei diesem Phasendetektor 400 wird auftretendes Driften in beiden Stellungen eines Hochfrequenzschalters 402 (Chopper-Schalter) unterdrückt. Hierbei befindet sich der zweite Phasendetektor 411 in der in Figur 4 gezeigten Stellung des Hochfrequenzschalters in der Kalibrationsphase, während sich der erste Phasendetektor 412 in der Messphase befindet, und umgekehrt. Alternativ zum Nullabgleich aus Figur 3 mittels einer Sample & Hold-Schaltung, können die Spannungssignale in diesem zweiten Ausführungsbeispiel während der Mess- und Kalibrationsphase mittels der ADC (Analog/Digital-Wandler) 413, 414 erfasst, mit einem FPGA 415 (Field Programmable Array) verrechnet und einem DAC 416 (Digital/Analog-Wandler) ausgegeben werden.

Wie in Figur 4 gezeigt, sind zwei Leistungsteiler 403, 404 vorgesehen, an deren Eingängen das Frequenzsignal $RF(f_0)$ bzw. $L0(f_0)$ anliegt. Der erste Ausgang des ersten Leistungsteilers 403 ist direkt mit dem ersten Eingang des ersten Phasendetektors 411 verbunden, und der zweite Ausgang des zweiten Leistungsteilers 404 ist direkt mit dem zweiten Eingang eines zweiten Phasendetektors 412 verbunden. Außerdem ist der zweite Ausgang des ersten Leistungsteilers 403 mit dem ersten Eingang des Hochfrequenzschalters 402 verbunden, und der erste Ausgang des zweiten Leistungsteilers 404 ist mit dem zweiten Eingang des Hochfrequenzschalters 402 verbunden. Der Ausgang des Hochfrequenzschalters 402 ist mit dem Eingang eines invers geschalteten dritten Leistungsteilers 405 verbunden, dessen zwei Ausgänge mit dem zweiten Eingang des ersten Phasendetektors 411 bzw. mit dem ersten Eingang des zweiten Phasendetektors 412 verbunden sind. Die beiden Ausgängen des ersten und des zweiten Phasendetektors 411, 412 sind jeweils mit der Nullabgleichs-Einheit 450 verbunden, und zwar, wie vorstehend erläutert, mit dem ADC 413 bzw. mit dem ADC 414. Aus Figur 4 ist offensichtlich, dass sich der zweite Phasendetektor 412 in der in Figur 4 gezeigten Stellung des Hochfrequenzschalters 402 in der Kalibrationsphase befindet, während sich der erste Phasendetektor 411 in der Messphase befindet, und umgekehrt.

Die Takterzeugungseinrichtung 460 arbeitet auf ähnliche Weise, wie oben unter Bezugnahme auf Figur 3 beschrieben.

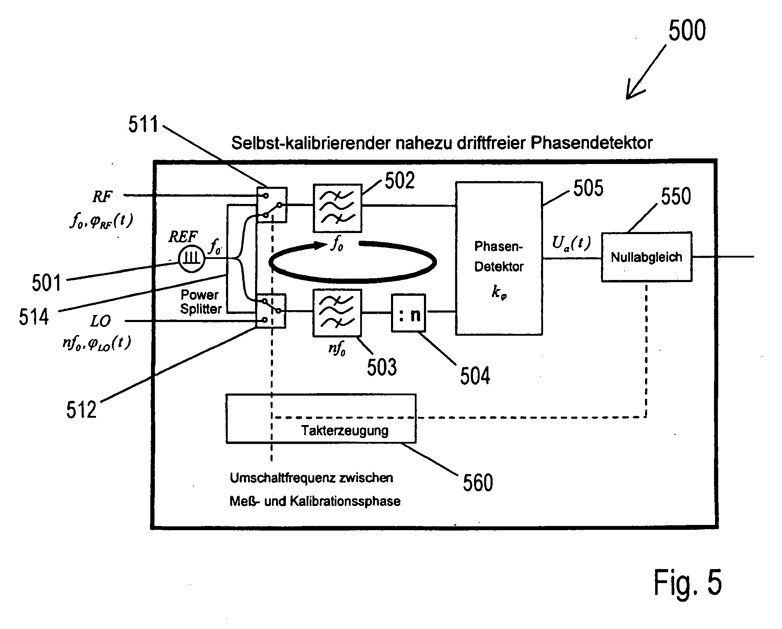

Im Fall unterschiedlicher zu vergleichender Frequenzen (siehe Figur 5) kann das Abgleichsprinzip gemäß einem weiteren dritten Ausführungsbeispiel der vorliegenden Erfindung erweitert werden, um auch Driften und 1/f-Rauschen von Hochfrequenzteilern zu unterdrücken. Hierzu wird eine gepulste Referenzquelle 501 benötigt, die zueinander voll korrelierten Phasenrauschspektren bzw. auf unterschiedlichen Frequenzen $f_{RF}$ bzw. $f_{LO}$ zur Verfügung stellt. Mit der Repetitionsrate der Pulsfolge $f_0$ gilt,

$$f_{RF} = m\, f_0 \quad \mathrm{mit} \quad S_{\varphi,RF}^{Ref} = m^2 S_{\varphi,f_0} , \tag{4}$$

$$f_{LO} = n\, f_0 \quad \mathrm{mit} \quad S_{\varphi,LO}^{Ref} = n^2 S_{\varphi,f_0} . \tag{5}$$

Für $m = 1$ reduzieren sich Gleichung (4) und (5) zu

$$\frac{\sqrt{S_{\varphi,RF}^{Ref}(f)}}{\sqrt{S_{\varphi,LO}^{Ref}(f)}} = \frac{1}{n} = \frac{f_{RF}}{f_{LO}} , \tag{6}$$

so dass die Referenzsignale mittels Bandpassfilterung (Bandpassfilter 502, 503) auf den Frequenzen $f_{RF}$, $f_{LO} = nf_{RF}$

für ganzahliges $n > 1$ während der Kalibrationsphase zur Verfügung stehen. Die gepulste Referenzquelle 501 kann mittels Hochfrequenzgeneratoren im GHz Bereich erzeugt werden oder mittels fs-Fiber-Lasern, dessen fs-Pulse mit direkter Photodiodendetektion in Hochfrequenzsignale konvertieren. Mit Hilfe der Eigenschaft des $n$-fachen Hochfrequenzteilers 504

$$S_{\varphi,LO}(f) = \frac{1}{n^2} S_{\varphi,LO}^{Ref}(f) \, , \qquad (7)$$

Gleichung (6) und $S_{\varphi,RF}(f) = S_{\varphi,RF}^{Ref}(f)$ eingesetzt in Gleichung (3) erhält man $S_\varphi(f) = 0$ und somit kein Spannungsrauschen von der Referenzquelle 501 am Ausgang des Phasendetektors während der Kalibrationsphase. Anderweitig auftretendes Phasenrauschen oder Driften innerhalb der Kalibrationsschleife, insbesondere vom Hochfrequenzteiler 504, kann somit unterdrückt werden. Der eigentliche Nullabgleich 550 ist identisch dem zweiten Ausführungsbeispiel aus Figur 3.

Insbesondere beinhaltet das in Figur 5 gezeigte Ausführungsbeispiel des erfindungsgemäßen Phasendetektor-Moduls 500, mit Hilfe dessen zwei unterschiedliche Frequenzen verarbeitet werden können, zwei Hochfrequenzschalter 511, 512, wobei am ersten Eingang des ersten Hochfrequenzschalters 511 das Frequenzsignal RF($f_0$) anliegt und am zweiten Eingang des zweiten Hochfrequenzschalters 512 das Frequenzsignal L0($nf_0$) anliegt. Außerdem ist ein Leistungsteiler 514 vorgesehen, an dessen Eingang das rechteckförmiges Referenzsignal REF($f_0$) von der Referenzquelle 501 anliegt. Der erste Ausgang des Leistungsteilers 514 ist mit dem zweiten Eingang eines ersten Hochfrequenzschalters 511 verbunden, und der zweite Ausgang des Leistungsteilers 514 ist mit dem ersten Eingang eines zweiten Hochfrequenzschalters 512 verbunden. Der Ausgang des ersten Hochfrequenzschalters 30 ist mit dem Eingang des ersten Bandpassfilters 502 verbunden, und der Ausgang des zweiten Hochfrequenzschalters 512 ist mit dem Eingang des zweiten Bandpassfilters 503 verbunden. Der Ausgang des zweiten Bandpassfilters 503 ist mit dem Hochfrequenzteiler 504 verbunden, um das eingehende Frequenzsignal durch den Faktor n zu dividieren. Sowohl der Ausgang des Hochfrequenzteilers 504 als auch der Ausgang des ersten Bandpassfilters 502 ist mit dem Phasendetektor 505 verbunden, dessen Ausgang mit dem Nullabgleich 550 verbunden ist. Auch hier sind der erste und der zweite Hochfrequenzschalter 511, 512 jeweils mit einem Steuereingang versehen, an dem jeweils eine Umschaltfrequenz von der Takterzeugungseinrichtung 560 anliegt, um die beiden Hochfrequenzschalter 511, 512 zwischen der Messphase und der Kalibrationsphase umzuschalten. Der Vorteil dieser Ausgestaltung besteht darin, dass die am Leistungsteiler 514 erzeugten Hochfrequenzsignale für ein rechteckförmiges Referenzsignal in all ihren harmonischen, insbesondere für die erste und zweite Harmonische voll phasenkorreliert sind und somit während der Kalibrationsphase als Nullabgleichssignal für den Ausgang des Phasendetektor-Moduls dienen, so dass zusätzlich auch das Driften von vorgeschalteten Hochfrequenzteilen berücksichtigt werden kann.

Das Verfahren kann ebenso zur driftfreien kontinuierlichen Amplitudenmessung von Hochfrequenzsignalen eingesetzt werden. Ausgehend vom Ausführungsbeispiel der Figur 3 wird hierzu auf einen Leistungsteiler verzichtet, und der Hochfrequenzschalter wird mit Null verbunden, um während der Kalibrationsphase eine definierte Amplitude der Höhe Null zur Verfügung zu stellen. In diesem Ausführungsbeispiel müssen natürlich alle Phasendetektoren durch Amplitudendetektoren ersetzt werden, was im Falle des rauscharmen Messzweiges aus Figur 2 durch Einhaltung einer 0-Grad-Bedingung mittels des Phasenschiebers $\Delta\varphi$ erfüllt ist.

**Patentansprüche**

1. Selbst-kalibrierendes Phasendetektor-Modul (300; 400; 500) mit:

zumindest einem Leistungsteiler (301; 403, 404; 514) zum Empfangen von zwei sinusförmigen Hochfrequenzsignalen (RF, L0), die eine Eingangsphasendifferenz ($CP_{RF}$ (t) -$CP_{L0}$ (t)) haben;
zumindest einem Phasendetektor (303; 411, 412; 505), der mit dem zumindest einen Leistungsteiler gekoppelt ist;
einer Nullabgleichseinrichtung (350; 450; 550), die mit dem zumindest einen Phasendetektor gekoppelt ist;
wobei zumindest ein Hochfrequenzschalter (302; 402; 511, 512) vorgesehen ist, der mit dem zumindest eine Leistungsteiler und dem zumindest einen Phasendetektor angeschlossen und betätigbar ist, um zwischen dem zumindest einen Leistungsteiler und dem zumindest einen Phasendetektor zwischen einer Messphase und einer Kalibrationsphase umzuschalten, um so eine Selbst-Kalibration zu bewirken.

2. Selbst-kalibrierendes Phasendetektor-Modul (300; 400; 500) nach Anspruch 1, **dadurch gekennzeichnet, dass** das Phasendetektor-Modul eine Takterzeugungseinrichtung (305; 460; 560) aufweist, um einen Takt zur Steuerung des zumindest einen Hochfrequenzschalters zu erzeugen, um zwischen der Messphase und der Kalibrationsphase umzuschalten.

3. Selbst-kalibrierendes Phasendetektor-Modul (300; 400; 500) nach Anspruch 1 oder 2, **dadurch gekennzeichnet, dass** der zumindest eine Hochfrequenzschalter während der Kalibrationsphase so geschaltet ist, dass an den Eingängen des zumindest einen Phasendetektors voll korrelierte Hochfrequenzsignale von einem der beiden sinusförmigen Hochfrequenzsignalen (RF, L0) oder von einem Referenzsignal zur Verfügung stehen, deren Phasendifferenz Null ist und die während der Kalibrationsphase als Nullabgleichssignale für den Detektorausgang dienen.

4. Selbst-kalibrierendes Phasendetektor-Modul (300; 400; 500) nach Anspruch 2 oder 3, **dadurch gekennzeichnet, dass** die Takterzeugungseinrichtung (305; 460; 560) mit der Nullabgleichseinrichtung gekoppelt ist, um diese mit der gleichen Taktfrequenz wie den zumindest einen Hochfrequenzschalter zu steuern.

5. Selbst-kalibrierendes Phasendetektor-Modul (300) nach einem der Ansprüche 1 bis 4, **dadurch gekennzeichnet, dass** ein Leistungsteiler (301), dessen Eingang mit einem der beiden sinusförmigen Hochfrequenzsignale (L0) gekoppelt ist, und ein Hochfrequenzschalter (302) mit zwei Eingängen und einem Ausgang vorgesehen sind, wobei das andere der beiden sinusförmigen Hochfrequenzsignale (RF) mit dem einen Eingang des Hochfrequenzschalters (302) gekoppelt ist und ein Ausgang des Leistungsteilers (301) mit dem anderen Eingang des Hochfrequenzschalters (302) gekoppelt ist, und dass der andere Ausgang des Leistungsteilers (301) und der Ausgang des Hochfrequenzschalters (302) mit den Eingängen des Phasendetektors (303) gekoppelt sind.

6. Selbst-kalibrierendes Phasendetektor-Modul (400) nach einem der Ansprüche 1 bis 4, **dadurch gekennzeichnet, dass** zwei Leistungsteiler (403, 404), deren Eingänge mit den beiden sinusförmigen Hochfrequenzsignalen (RF, L0) gekoppelt ist, und ein Hochfrequenzschalter (402) mit zwei Eingängen und einem Ausgang vorgesehen sind, wobei jeweils einer der beiden Ausgänge der beiden Leistungsteiler (403, 404) mit jeweils einem der beiden Eingänge des Hochfrequenzschalters (402) gekoppelt ist, und der jeweils andere Ausgang der beiden Leistungsteiler (403, 404) mit jeweils einem Eingang von jeweils einem von zwei Phasendetektoren (411, 412) gekoppelt ist, und dass ein invers geschalteter Leistungsteiler (405) vorgesehen ist, dessen Eingang mit dem Ausgang des Hochfrequenzschalter (402) gekoppelt ist und dessen zwei Ausgänge jeweils mit einem der anderen Eingänge der beiden Phasendetektoren (411, 412) gekoppelt sind.

7. Selbst-kalibrierendes Phasendetektor-Modul (500) nach einem der Ansprüche 1 bis 4, **dadurch gekennzeichnet, dass** ein Leistungsteiler (514) mit einem Eingang und zwei Ausgängen, dessen Eingang mit einer gepulsten Referenzsignalquelle (501) zur Bereitstellung phasenkorrelierter Signale auf unterschiedlichen Frequenzen gekoppelt ist, und zwei Hochfrequenzschalter (511, 512) mit jeweils zwei Eingängen und einem Ausgang vorgesehen sind, wobei jeweils einer der beiden Eingänge der Hochfrequenzschalter (511, 512) mit einer der beiden sinusförmigen Hochfrequenzsignalen (RF, L0) gekoppelt ist und der jeweils andere Eingang der Hochfrequenzschalter (511, 512) mit jeweils einem Ausgang des Leistungsteilers (514) gekoppelt ist, und dass der Ausgang der jeweiligen Hochfrequenzschalter (511, 512) jeweils mit einem von zwei Eingängen eines Phasendetektors (505) gekoppelt ist.

8. Selbst-kalibrierendes Phasendetektor-Modul (500) nach Anspruch 7, **dadurch gekennzeichnet, dass** zwischen dem Ausgang von jedem der Hochfrequenzschalter (511, 512) und den jeweiligen Eingängen des Phasendetektors (505) jeweils ein Bandpassfilter (502, 503) vorgesehen ist.

9. Selbst-kalibrierendes Phasendetektor-Modul (500) nach einem der Ansprüche 7 oder 8, **dadurch gekennzeichnet, dass** das eine Hochfrequenzsignal (RF) eine Frequenz ($f_0$) um etwa 1 GHz hat und das andere Hochfrequenzsignal (L0) eine Frequenz ($n \cdot f_0$) hat, die gleich dem n-fachen der Frequenz des einen Hochfrequenzsignals (RF) ist, wobei n > 1 eine Ganzzahl ist.

10. Selbst-kalibrierendes Phasendetektor-Modul (500) nach Anspruch 8, **dadurch gekennzeichnet, dass** zwischen dem Ausgang von dem Hochfrequenzschalter (512), an dem das sinusförmige Hochfrequenzsignal ($L_0$) anliegt, dessen Frequenz gleich der n-fachen Frequenz des anderen sinusförmigen Hochfrequenzsignale (RF) ist, und dem zugehörigen Eingang des Phasendetektors (505) außerdem ein Hochfrequenzteiler (504) vorgesehen ist, um die eingehende Frequenz durch den Faktor n zu teilen.

11. Phasendetektor-Schaltung (10) mit:

einer RF-Verteilungseinrichtung (20) zum Empfangen von zwei sinusförmigen Hochfrequenzsignalen (RF, L0) mit einer Eingangsphasendifferenz ($\varphi_{RF}$(t) - $\varphi_{L0}$(t)), die zwei Leistungsteiler (21, 22) beinhaltet, um die beiden Hochfrequenzsignale (RF, L0) in jeweils zwei Teile aufzuspalten;
einem selbst-kalibrierenden Phasendetektor-Modul (30) nach einem der Ansprüche 1 bis 10, das ausgestaltet ist, um den jeweils einen Teil der beiden aufgespaltenen Hochfrequenzsignale zu empfangen;
einem rauscharmen Phasendetektor-Modul (40), das ausgestaltet ist, um den jeweils anderen Teil der aufgespaltenen Hochfrequenzsignale zu empfangen; und
einer komplementären Filtereinrichtung (50), die ausgestaltet ist, um die Ausgangssignale von dem selbst-kalibrierenden Phasendetektor-Modul (30) und dem rauscharmen Phasendetektor-Modul (40) zu empfangen, und um ein Signal auszugeben, das die zeitabhängige Eingangsphasendifferenz der beiden Hochfrequenzsignale (RF, L0) angibt.

12. Phasendetektor-Schaltung (10) nach Anspruch 11, **dadurch gekennzeichnet, dass** das Hochfrequenzsignal (RF) eine Frequenz ($f_0$) um etwa 1 GHz hat und dass das andere Hochfrequenzsignal (L0) eine Frequenz (n·$f_0$) hat, die gleich dem n-fachen der Frequenz des einen Hochfrequenzsignals (RF) hat, wobei n $\geq$ 1 eine Ganzzahl ist.

13. Phasendetektorschaltung (10) nach einem der Ansprüche 11 und 12, **dadurch gekennzeichnet, dass** die komplementäre Filtereinrichtung (50) einen Widerstand (51) und eine in Reihe geschaltete Kapazität (52) aufweist, um einen RC-Tiefpass/Hochpass erster Ordnung zu bilden, der mit dem selbst-kalibrierenden Phasendetektor-Modul (30) und dem rauscharmen Phasendetektor-Modul (40) verbunden ist, wobei die zeitabhängige Eingangsphasendifferenz der beiden Hochfrequenzsignale (RF, L0) am Ausgang des RC-Tiefpass/Hochpass anliegt.

14. Phasendetektor-Schaltung (10) nach Anspruch 13, **dadurch gekennzeichnet, dass** der RC-Tiefpass/Hochpass erster Ordnung (51, 52) mit einem Impedanzwandler (53) gekoppelt ist.

15. Phasendetektor-Schaltung (10) nach einem der Ansprüche 11 bis 14, **dadurch gekennzeichnet, dass** die Eckfrequenz der komplementären Filtereinrichtung (50) etwa 1-100 Hz beträgt.

16. Phasendetektor-Schaltung (10) nach einem der Ansprüche 11 bis 15, **dadurch gekennzeichnet, dass** die RF-Verteilungseinrichtung (20) einen Phasenschieber (23) aufweist, um Phasenunterschiede ($\Delta\varphi_0$) zu kompensieren, die durch Laufzeitunterschiede verursacht werden.

17. Phasendetektor-Schaltung (10) nach einem der Ansprüche 11 bis 16, **dadurch gekennzeichnet, dass** die RF-Verteilungseinrichtung (20) temperaturstabilisiert ist, um auftretende Phasendriften der Leistungsteiler (21, 22) und der Kabel zu minimieren.

18. Phasendetektor-Schaltung (10) nach einem der Ansprüche 11 bis 17, **dadurch gekennzeichnet, dass** jeder der Leistungsteiler (21, 22) einen Eingang und zwei Ausgänge hat, wobei am Eingang des ersten Leistungsteilers (21) das eine Hochfrequenzsignal (RF) anliegt und am Eingang des zweiten Leistungsteilers (22) das andere Hochfrequenzsignal (LO) anliegt, wobei die beiden Hochfrequenzsignale (RF, LO) durch die zugehörigen Leistungsteiler (21, 22) aufgespalten und jeweils einem Eingang der beiden Phasendetektor-Module (30, 40) zugeführt werden.

19. Phasendetektor-Schaltung (10) nach einem der Ansprüche 11 bis 18, **dadurch gekennzeichnet, dass** das rauscharme Phasendetektor-Modul (40) einen passiven Diodenmischer (41) aufweist, der mit einem manuellen Phasenschieber (42) gekoppelt und mit einem Tiefpassfilter (43) verbunden ist.

20. Phasendetektor-Schaltung (10) nach Anspruch 19, **dadurch gekennzeichnet, dass** der Tiefpassfilter (42) mit einem rauscharmen, dc-gekoppelten Operationsverstärker (44) gekoppelt ist, an dessen Ausgang die Phasendifferenz in Form einer Spannung anliegt.

21. Phasendetektor-Schaltung (10) nach Anspruch 19 oder 20, **dadurch gekennzeichnet, dass** der Tiefpassfilter (42) eine Eckfrequenz von etwa 10 MHz hat.

22. Phasendetektor-Schaltung (10) nach Anspruch 20 oder 21, **dadurch gekennzeichnet, dass** die Verstärkung $g_0$ des Operationsverstärkers (44) so eingestellt ist, dass die Phasen-zu-Spannung-Konversionskoeffizienten $k_\varphi$ beider Phasendetektor-Module (30, 40) etwa gleich sind.

**Claims**

1. A self-calibrating phase detector module (300; 400; 500) comprising:

     at least one power splitter (301; 403, 404; 514) for receiving two sinusoidal high-frequency signals (RF, LO) having an input phase difference ($\varphi_{RF}$(t) - $\varphi_{LO}$(t));
     at least one phase detector (303; 411, 412; 505) which is coupled to the at least one power splitter;
     a zero adjustment device (350; 450; 550) which is coupled to the at least one phase detector;
     wherein at least one high-frequency switch (302; 402; 511, 512) being provided which is connected to the at least one power splitter and to the at least one phase detector and which can be activated to switch over between the at least one power splitter and the at least one phase detector between a measuring phase and a calibration phase in order to cause a self-calibration.

2. A self-calibrating phase detector module (300; 400; 500) according to claim 1, **characterized in that** the phase detector module comprises a clock generation device (305; 460; 560) in order to generate a clock signal for controlling the at least one high-frequency switch in order to switch over between the measuring phase and the calibration phase.

3. A self-calibrating phase detector module (300; 400; 500) according to claim 1 or 2, **characterized in that** the at least one high-frequency switch is connected during the calibration phase in such a way that fully correlated high-frequency signals of one of the two sinusoidal high-frequency signals (RF, LO) or of a reference signal are provided at the inputs of the at least one phase detector whose phase difference is zero and which serve during the calibration phase as zero adjustment signals for the detector output.

4. A self-calibrating phase detector module (300; 400; 500) according to claim 2 or 3, **characterized in that** the clock generation device (305; 460; 560) is coupled to the zero adjustment device in order to control the zero adjustment device with the same clock frequency as the at least one high-frequency switch.

5. A self-calibrating phase detector module (300) according to one of the claims 1 to 4, **characterized in that** a power splitter (301) whose input is coupled to one of said both sinusoidal high-frequency signals (LO) and a high-frequency switch (302) having two inputs and one output are provided, wherein the other of the two sinusoidal high-frequency signals (RF) is coupled to the one input of said high-frequency switch (302) and wherein one output of the power splitter (301) is coupled to the other input of the high-frequency switch (302), and that the other output of the power splitter (301) and the output of the high-frequency switch (302) are coupled to the inputs of the phase detector (303).

6. A self-calibrating phase detector module (400) according to one of the claims 1 to 4, **characterized in that** two power splitters (403, 404) whose inputs are coupled to the both sinusoidal high-frequency signals (RF, LO) and a high-frequency switch (402) having two inputs and one output are provided, wherein a respective one of the two outputs of the two power splitters (403, 404) is coupled to a respective one of the two inputs of the high-frequency switch (402) and the respective other output of the two power splitters (403, 404) is coupled to a respective input of a respective one of two phase detectors (411, 412), and that an inversely connected power splitter (405) is provided whose input is coupled to the output of the high-frequency switch (402) and whose two outputs are each coupled to one of the other inputs of the two phase detectors (411, 412).

7. A self-calibrating phase detector module (500) according to one of the claims 1 to 4, **characterized in that** one power splitter (514) having one input and two outputs whose input is coupled to a pulsed reference signal source (501) for providing phase correlated signals on different frequencies, and two high-frequency switches (511, 512) are provided, each having two inputs and one output, wherein a respective one of the two inputs of the high-frequency switches (511, 512) is coupled to one of the two sinusoidal high-frequency signals (RF, LO) and the respective other input of the high-frequency switches (511, 512) is coupled to a respective output of the power splitter (514), and that the output of the respective high-frequency switches (511, 512) is each coupled to one of two inputs of a phase detector (505).

8. A self-calibrating phase detector module (500) according to claim 7, **characterized in that** a band pass filter (502, 503) is each provided between the output of each of the high-frequency switches (511, 512) and the respective inputs of the phase detector (505).

9. A self-calibrating phase detector module (500) according to one of the claims 7 or 8, **characterized in that** the one high-frequency signal (RF) has a frequency ($f_0$) of about 1 GHz and that the other high-frequency signal (LO) has

a frequency (n·$f_0$) which is equal to the n-fold frequency of the one high-frequency signal (RF), wherein n ≥ 1 is an integer.

**10.** A self-calibrating phase detector module (500) according to claim 8, **characterized in that** between the output of the high-frequency switch (512) to which the sinusoidal high-frequency signal (LO) is applied whose frequency is equal to the n-fold frequency of the other sinusoidal high-frequency signals (RF) and the respective input of the phase detector (505) a high-frequency divider (505) is additionally provided to divide the incoming frequency by the factor n.

**11.** A phase detector circuit (10) comprising:

an RF distribution device (20) for receiving two sinusoidal high-frequency signals (RF, LO) with an input phase difference ($\varphi_{RF}(t) - \varphi_{LO}(t)$) and which comprises two power splitters (21, 22) in order to split the two high-frequency signals (RF, LO) into two respective parts;
a self-calibrating phase detector module (30) according to one of the claims 1 to 10 which is configured to receive the respective one part of the two high-frequency signals which have been split;
a low-noise phase detector module (40) which is configured to receive the respective other part of the high-frequency signals which have been split; and
a complementary filter device (50) which is configured to receive the output signals from the self-calibrating phase detector module (30) and the low-noise phase detector module (40) and to output a signal which indicates the time-dependent input phase difference between the two high-frequency signals (RF, LO).

**12.** A phase detector circuit (10) according to claim 11, **characterized in that** the high-frequency signal (RF) has a frequency ($f_0$) of about 1 GHz and that the other high-frequency signal (LO) has a frequency (n·$f_0$) which is equal to the n-fold frequency of the one high-frequency signal (RF), wherein n ≥ 1 is an integer.

**13.** A phase detector circuit (10) according to one of the claims 11 and 12, **characterized in that** the complementary filter device (50) comprises a resistance (51) and a capacity (52) connected in series in order to form an RC low pass/high pass of first order which is connected to the self-calibrating phase detector module (30) and to the low-noise phase detector module (40), wherein the time-dependent input phase difference between the two high-frequency signals (RF, LO) is applied at the output of the RC low pass/high pass.

**14.** A phase detector circuit (10) according to claim 13, **characterized in that** the RC low pass/high pass of first order (51, 52) is coupled to an impedance converter (53).

**15.** A phase detector circuit (10) according to one of the claims 11 to 14, **characterized in that** the cut-off frequency of the complementary filter device (50) is about 1-100 Hz.

**16.** A phase detector circuit (10) according to one of the claims 11 to 15, **characterized in that** the RF distribution device (20) comprises a phase shifter (23) in order to compensate phase differences ($\Delta\varphi_0$) caused by runtime differences.

**17.** A phase detector circuit (10) according to one of the claims 11 to 16, **characterized in that** the RF distribution device (20) is temperature-stabilized in order to minimize phase drifts of the power splitters (21, 22) and of the cables.

**18.** A phase detector circuit (10) according to one of the claims 11 to 16, **characterized in that** each of the power splitters (21, 22) comprises one input and two outputs, wherein the one high-frequency signal (RF) is applied to the input of said first power splitter (21) and the other high-frequency signal (LO) is applied to the input of said second power splitter (22), wherein the two high-frequency signals (RF, LO) being split by the respective power splitter (21, 22) and being each fed to an input of the two phase detector modules (30, 40).

**19.** A phase detector circuit (10) according to one of the claims 11 to 18, **characterized in that** the low-noise phase detector module (40) comprises a passive diode mixer (41) which is coupled to a manually operated phase shifter (42) and which is connected to a low pass filter (43).

**20.** A phase detector circuit (10) according to claim 19, **characterized in that** the low pass filter (42) is coupled to a low-noise, dc-coupled operational amplifier (44) to whose output the phase difference is applied in the form of a voltage.

**21.** A phase detector circuit (10) according to claim 19 or 20, **characterized in that** the low pass filter has a cut-off frequency of about 10 MHz.

**22.** A phase detector circuit (10) according to claim 20 or 21, **characterized in that** the gain go of the operational amplifier (44) is adjusted such that the phase-to-voltage-conversion coefficients $k_\varphi$ of each of the phase detector modules (30, 40) are approximately the same.

**Revendications**

**1.** Module détecteur de phase à auto-étalonnage (300 ; 400 ; 500) comprenant : au moins un diviseur de puissance (301 ; 403, 404 ; 514) pour la réception de deux signaux sinusoïdaux à haute fréquence (RF, LO) qui ont une différence de phase d'entrée ($\varphi_{RF}$ (t) - ($\varphi_{LO}$(t)) ; au moins un détecteur de phase (303 ; 411, 412 ; 505) couplé audit au moins un diviseur de puissance ; un dispositif de compensation à zéro (350 ; 450 ; 550) couplé audit au moins un détecteur de phase ; dans lequel il est prévu au moins un commutateur à haute fréquence (302 ; 402 ; 511, 512) qui est connecté audit au moins un diviseur de puissance et audit au moins un détecteur de phase et qui peut être actionné pour commuter entre ledit au moins un diviseur de puissance et ledit au moins un détecteur de phase entre une phase de mesure et une phase d'étalonnage afin de réaliser ainsi un auto-étalonnage.

**2.** Module détecteur de phase à auto-étalonnage (300 ; 400 ; 500) selon la revendication 1, **caractérisé en ce que** le module détecteur de phase comporte un dispositif générateur d'horloge (305 ; 460 ; 560) permettant de générer un signal d'horloge pour commander ledit au moins un commutateur à haute fréquence afin de commuter entre la phase de mesure et la phase d'étalonnage.

**3.** Module détecteur de phase à auto-étalonnage (300 ; 400 ; 500) selon la revendication 1 ou 2, **caractérisé en ce que** ledit au moins un commutateur à haute fréquence est commuté pendant la phase d'étalonnage, de façon que soient disponibles, aux entrées dudit au moins un détecteur de phase, des signaux à haute fréquence totalement corrélés d'un des deux signaux sinusoïdaux à haute fréquence (RF, LO) ou d'un signal de référence dont la différence de phase est nulle et qui, pendant la phase d'étalonnage, servent de signaux de compensation à zéro pour la sortie du détecteur.

**4.** Module détecteur de phase à auto-étalonnage (300 ; 400 ; 500) selon la revendication 2 ou 3, **caractérisé en ce que** le dispositif générateur d'horloge (305 ; 460 ; 560) est couplé au dispositif de compensation à zéro pour commander celui-ci avec la même fréquence d'horloge que ledit au moins un commutateur à haute fréquence.

**5.** Module détecteur de phase à auto-étalonnage (300) selon une des revendications 1 à 4, **caractérisé en ce qu'**un diviseur de puissance (301), dont l'entrée est couplée à un des deux signaux sinusoïdaux à haute fréquence (LO), et un commutateur à haute fréquence (302) à deux entrées et une sortie sont prévus, l'autre des deux signaux sinusoïdaux à haute fréquence (RF) étant couplé à une entrée du commutateur à haute fréquence (302), et une sortie du diviseur de puissance (301) étant couplée à l'autre entrée du commutateur à haute fréquence (302), et **en ce que** l'autre sortie du diviseur de puissance (301) et la sortie du commutateur à haute fréquence (302) sont couplées aux entrées du détecteur de phase (303).

**6.** Module détecteur de phase à auto-étalonnage (400) selon une des revendications 1 à 4, **caractérisé en ce que** deux diviseurs de puissance (403, 404), dont les entrées sont couplées aux deux signaux sinusoïdaux à haute fréquence (RF, LO), et un commutateur à haute fréquence (402) à deux entrées et une sortie sont prévus, à chaque fois une des deux sorties des deux diviseurs de puissance (403, 404) étant couplée à chaque fois à une des deux entrées du commutateur à haute fréquence (402), et à chaque fois l'autre sortie des deux diviseurs de puissance (403, 404) étant couplée à chaque fois à une entrée d'à chaque fois un de deux détecteurs de phase (411, 412), et **en ce qu'**il est prévu un diviseur de puissance (405) monté en inverse dont l'entrée est couplée à la sortie du commutateur à haute fréquence (402) et dont les deux sorties sont à chaque fois couplées à une des autres entrées des deux détecteurs de phase (411, 412).

**7.** Module détecteur de phase à auto-étalonnage (500) selon une des revendications 1 à 4, **caractérisé en ce qu'**un diviseur de puissance (514) à une entrée et deux sorties, dont l'entrée est couplée à une source de signal de référence pulsée (501) permettant de mettre à disposition des signaux corrélés en phase à différentes fréquences, et deux commutateurs à haute fréquence (511, 512) à chaque fois à deux entrées et une sortie sont prévus, à chaque fois une des deux entrées des commutateurs à haute fréquence (511, 512) étant couplée à un des deux signaux sinusoïdaux à haute fréquence (RF, LO) et l'autre entrée respective des commutateurs à haute fréquence (511, 512) étant couplée à chaque fois à une sortie du diviseur de puissance (514), et **en ce que** la sortie des commutateurs à haute fréquence (511, 512) respectifs est à chaque fois couplée à une de deux entrées d'un détecteur de phase (505).

8. Module détecteur de phase à auto-étalonnage (500) selon la revendication 7, **caractérisé en ce qu'**un filtre passe-bande (502, 503) est à chaque fois prévu entre la sortie de chacun des commutateurs à haute fréquence (511, 512) et les entrées respectives du détecteur de phase (505).

9. Module détecteur de phase à auto-étalonnage (500) selon une des revendications 7 ou 8, **caractérisé en ce qu'**un signal à haute fréquence (RF) a une fréquence ($f_0$) d'environ 1 GHz et l'autre signal à haute fréquence (LO) a une fréquence ($n \cdot f_0$) qui est égale à n fois la fréquence du signal à haute fréquence (RF), n étant un nombre entier > 1.

10. Module détecteur de phase à auto-étalonnage (500) selon la revendication 8, **caractérisé en ce qu'**il est également prévu un diviseur à haute fréquence (504) entre la sortie du commutateur à haute fréquence (512), à laquelle le signal sinusoïdal à haute fréquence (LO) est présent, dont la fréquence est égale à n fois la fréquence de l'autre signal sinusoïdal à haute fréquence (RF), et l'entrée correspondante du détecteur de phase (505), pour diviser la fréquence entrante par le facteur n.

11. Circuit détecteur de phase (10) comprenant un dispositif de répartition RF (20) pour la réception de deux signaux sinusoïdaux à haute fréquence (RF, LO) ayant une différence de phase d'entrée ($\varphi_{RF}(t) - \varphi_{L0}(t)$), qui contient deux diviseurs de puissance (21, 22) pour diviser les deux signaux à haute fréquence (RF, LO) en à chaque fois deux parties ; un module détecteur de phase à auto-étalonnage (30) selon une des revendications 1 à 10, qui est conçu pour recevoir à chaque fois une partie des deux signaux à haute fréquence divisés ; un module détecteur de phase à faible bruit (40) qui est conçu pour recevoir à chaque fois l'autre partie des signaux à haute fréquence divisés ; et un dispositif de filtrage complémentaire (50) qui est conçu pour recevoir les signaux de sortie du module détecteur de phase à auto-étalonnage (30) et du module détecteur de phase à faible bruit (40), et pour délivrer un signal qui indique la différence de phase d'entrée en fonction du temps des deux signaux à haute fréquence (RF, LO).

12. Circuit détecteur de phase (10) selon la revendication 11, **caractérisé en ce que** le signal à haute fréquence (RF) a une fréquence ($f_0$) d'environ 1 GHz et **en ce que** l'autre signal à haute fréquence (LO) a une fréquence ($n \cdot f_0$) qui est égale à n fois la fréquence du signal à haute fréquence (RF), n étant un nombre entier $\geq$ 1.

13. Circuit détecteur de phase (10) selon une des revendications 11 et 12, **caractérisé en ce que** le dispositif de filtrage complémentaire (50) comporte une résistance (51) et une capacité (52) montée en série pour former un filtre RC passe-bas/passe-haut de premier ordre qui est relié au module détecteur de phase à auto-étalonnage (30) et au module détecteur de phase à faible bruit (40), la différence de phase d'entrée en fonction du temps des deux signaux à haute fréquence (RF, LO) étant présente à la sortie du filtre RC passe-bas/passe-haut.

14. Circuit détecteur de phase (10) selon la revendication 13, **caractérisé en ce que** le filtre RC passe-bas/passe-haut de premier ordre (51, 52) est couplé à un convertisseur d'impédance (53).

15. Circuit détecteur de phase (10) selon une des revendications 11 à 14, **caractérisé en ce que** la fréquence de coupure du dispositif de filtrage complémentaire (50) est d'environ 1 à 100 Hz.

16. Circuit détecteur de phase (10) selon une des revendications 11 à 15, **caractérisé en ce que** le dispositif de répartition RF (20) comporte un déphaseur (23) pour compenser les différences de phase ($\Delta\varphi_0$) provoquées par les différences de temps de parcours.

17. Circuit détecteur de phase (10) selon une des revendications 11 à 16, **caractérisé en ce que** le dispositif de répartition RF (20) est stabilisé en température pour minimaliser les dérives de phase des diviseurs de puissance (21, 22) et des câbles.

18. Circuit détecteur de phase (10) selon une des revendications 11 à 17, **caractérisé en ce que** chacun des diviseurs de puissance (21, 22) a une entrée et deux sorties, un signal à haute fréquence (RF) étant présent à l'entrée du premier diviseur de puissance (21) et l'autre signal à haute fréquence (LO) étant présent à l'entrée du deuxième diviseur de puissance (22), les deux signaux à haute fréquence (RF, LO) étant divisés par les diviseurs de puissance (21, 22) correspondants et amenés à chaque fois à une entrée des deux modules détecteurs de phase (30, 40).

**19.** Circuit détecteur de phase (10) selon une des revendications 11 à 18, **caractérisé en ce que** le module détecteur de phase à faible bruit (40) comporte un mélangeur à diodes passif (41) qui est couplé à un déphaseur manuel (42) et relié à un filtre passe-bas (43).

**20.** Circuit détecteur de phase (10) selon la revendication 19, **caractérisé en ce que** le filtre passe-bas (42) est couplé à un amplificateur opérationnel (44) à faible bruit et à couplage continu, à la sortie duquel la différence de phase est présente sous la forme d'une tension.

**21.** Circuit détecteur de phase (10) selon la revendication 19 ou 20, **caractérisé en ce que** le filtre passe-bas (42) a une fréquence de coupure d'environ 10 MHz.

**22.** Circuit détecteur de phase (10) selon la revendication 20 ou 21, **caractérisé en ce que** l'amplification $g_0$ de l'amplificateur opérationnel (44) est réglée de façon que les coefficients de conversion phase/tension $k_\varphi$ des deux modules détecteurs de phase (30, 40) soient à peu près égaux.

Phasenstarre Erzeugung von Frequenzen mittels einer Phase-Lock-Loop (PLL)

Fig. 1

EP 2 020 079 B1

**Fig. 2**

20 — RF-Verteilung — 23

30 — Phasendetektoren

Komplementär-Filter — 50

21

$RF$
$f_0, \varphi_{RF}(t)$

$\Delta\varphi_0$
Phasenschieber

Power Splitter

Power Splitter

22

$LO$
$f_0, \varphi_{LO}(t)$

temperaturstabilisiert

Selbst-kalibrierender nahezu driftfreier Phasendetektor
$k_\varphi$

Rauscharmer Phasendetektor $k_\varphi$

DBM

Tiefpaß
$f_g \approx 10MHz$

LNA
$g_0$

$\Delta\varphi$
Phasenschieber

42    40    41    43    44

10

Tiefpaß
$f_g \approx 10Hz$

$R$ — 51

$C$ — 52

53

Phasendetektor Ausgangsspannung

$U_a(t) \propto$
$[\varphi_{RF}(t) - \varphi_{LO}(t)]$

Hochpaß
$f_g \approx 10Hz$

EP 2 020 079 B1

Fig. 3

EP 2 020 079 B1

EP 2 020 079 B1

Selbst-kalibrierender nahezu driftfreier Phasendetektor

Fig. 4

Fig. 5

EP 2 020 079 B1

**EP 2 020 079 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3883755 A
- US 4042885 A
- US 4155050 A
- US 4389621 A
- US 4728884 A
- US 4937537 A
- US 5210509 A
- US 6087897 A
- US 6167242 A
- US 6242974 B
- US 6340903 B
- US 6476671 B
- US 6781450 B
- US 6937684 B
- EP 0540052 A
- EP 1184972 A
- WO 9936792 A
- WO 0120350 A
- US 5614861 A